# EUROPEAN PATENT APPLICATION

(11) **EP 2 667 419 A2**
(43) Date of publication of application: **27.11.2013**
(21) Application number: 13167789.0
(22) Date of filing: 15.05.2013
(51) Int. Cl.: H01L 31/0216

(54) **Solar cell and module thereof**

(30) Priority: 22.05.2012 TW 101118258
(71) Applicant: Neo Solar Power Corp., Hsinchu City 300 (TW)
(72) Inventor: Chuang, Shang-Yu, 300 Hsinchu City (TW); Lo, Pei-Ting, 300 Hsinchu City (TW); Tai, Yu-Wei, 300 Hsinchu City (TW); Chen, Wei-Ming, 300 Hsinchu City (TW)
(74) Representative: Viering, Jentschura & Partner

(57) **Abstract**

A solar cell includes a silicon semiconductor substrate, a composite multifunctional protective film, a plurality of front electrodes and a plurality of back electrodes. The silicon semiconductor substrate has a roughened first surface. A depth of the doped layer arranged under the first surface ranges from 200 nm to 1000 nm. A surface doping concentration of the doped layer ranges from 1×10¹⁹ to 5×10²⁰ atoms/cm³. The composite multifunctional protective film is disposed above the doped layer. The composite multifunctional protective film has a plurality of layers, so as to reduce reflectance of incident light. A layer thickness of a layer closest to the doped layer among these layers is less than 40 nm. The plurality of front electrodes penetrates the composite multifunctional protective film and is disposed on the doped layer. The plurality of back electrodes is disposed on a second surface of the silicon semiconductor substrate.

## Description

### BACKGROUND OF THE INVENTION

### Technical Field

The present invention relates to a cell, and more particularly to a solar cell and a module thereof.

### Related Art

Due to the increasing shortage of fossil fuels, people are more and more aware of the importance of environmental protection. Consequently, in recent years people have actively studied technologies related to alternative energy sources and renewable energy sources, hoping to reduce human dependence on fossil energy and influence on the environment due to the use of fossil energy. Among the many technologies of alternative energy sources and renewable energy sources, the solar cell is most anticipated. The main reason for this is that the solar cell can directly convert solar energy into electric energy, and no harmful substances such as carbon dioxide or nitride are generated during the power generation process, so no pollution is caused to the environment.

Generally speaking, in the conventional silicon solar cell, counter-doping is usually performed on a surface of a semiconductor substrate by diffusion or ion implantation, so as to form a doped layer and make electrodes. When light impinges on the silicon solar cell from the outside, the doped layer generates free electron-hole pairs as being excited by a photon. The electrons and holes are separated through an inner electric field formed by a P-N junction, and respectively move towards two ends, thereby generating the form of electric energy. At this time, if an external load circuit or electronic device is added, the electric energy can be provided to drive the circuit or device.

According to different materials, the solar cells are classified into silicon (monocrystalline silicon, polycrystalline silicon, and amorphous silicon), solar cell, III-V compound semiconductor (GaAs, GaP, InP and so on), solar cell, II-VI compound semiconductor (CdS, CdSe, CdTe and so on)), solar cell, and organic semiconductor solar cell. At present, the monocrystalline silicon and polycrystalline silicon solar cells made of silicon are the mainstream solar cells, and the amorphous silicon can be applied to a thin film solar cell. The solar cells made of different materials may be different in processes, properties of matched materials, and cell structures (layer structures), due to different material properties thereof.

In solar cells using monocrystalline silicon or polycrystalline silicon as the base material, a wafer with original uniform doping is used as a substrate for the silicon, and a diffusion process opposite the doping of the substrate is performed on a region close to a surface of the substrate, thereby diffusing the doping. For example, the original wafer is of P-type doping, N-type doping is performed on one surface of the wafer through a phosphorus (P) diffusion process, and then P+ doping is performed on the other surface by use of boron or aluminum. The part under N-type doping is a light receiving surface, so an anti-reflection coating (ARC) is usually formed on the surface thereof to enhance the intensity of incident light. However, an interface between the N-type doping (emitters), and the ARC has a problem, that is, electrons and holes are recombined on this surface. That is, if the doping concentration is increased (for example, doping concentration > 10²¹ atoms/cm³), a surface recombination velocity (SRV) is increased, leading to a decrease of a short circuit current (Isc) and an open circuit voltage (Voc), further resulting in lower photoelectric conversion efficiency of the solar cell. In addition, on the interface between the N-type doping and the electrodes, a low N-type doping concentration (for example, doping concentration < 10¹⁹ atoms/cm³), may lead to a high contact resistance (Rc), which also causes a series resistance (Rs) of the entire assembly to rise, resulting in lower solar cell efficiency.

A high doping concentration may lead to low Voc and Isc because a junction of the high doping concentration is formed with a lot of recombination centers, and therefore free electrons and holes generated during light irradiation are eliminated at these recombination centers; that is, the SRV is high. In addition, a contact surface between front electrodes and the doped layer may have a lot of dangling bonds, and in this case, the free electrons and holes are easily recombined at a position close to the contact surface between the doped layer and the front electrodes, thereby reducing the photoelectric conversion efficiency of the silicon solar cell.

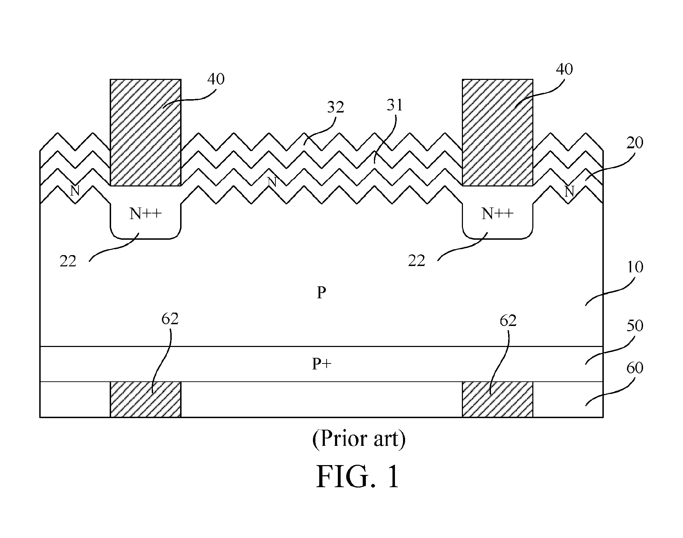

Due to these properties, the general design of the silicon-based solar cell tends to reduce the doping concentration of the light receiving surface to increase the Isc, and to increase the doping concentration at the electrode part to reduce the Rc thereof, thereby achieving optimal solar cell properties. Such a development trend introduces a design concept of selective emitters. Please refer to FIG. 1, which is a schematic sectional layered view of a solar cell based on the design concept of selective emitters, which includes surface electrodes 40, an ARC 32, an ARC 31, a lightly doped layer 20, a heavily doped layer 22, a silicon semiconductor substrate 10 (P-type semiconductor substrate), a P+ doped layer 50, a back electrode layer 60, and back electrodes 62 in sequence. It can be seen from FIG. 1 that, an N++ region of a high doping concentration (for example, greater than 1×10²¹ atoms/cm³), namely, the heavily doped layer 22, is made under the surface electrodes 40, so as to achieve an objective of Rc reduction (R↓). An N region of a low doping concentration (for example, 1×10¹⁹ atoms/cm³), namely, the lightly doped layer 20, is made in other regions that are irradiated by light. A diffusion process is usually adopted in the N-type doping process, in which phosphorus (in vapor or liquid state), of a high concentration is used to achieve an anticipated doping concentration by controlling temperature and diffusion time. Generally speaking, phosphorus of a low concentration is used in light doping, and phosphorus of a high concentration is used in heavy doping. In the diffusion process, the high-concentration phosphorus doping brings in a great diffusion depth, for example, greater than 1 µm, as shown by the heavily doped layer 22 in FIG. 1; the low-concentration phosphorus doping brings in a shallow diffusion depth, for example, less than 0.2 µm, as shown by the lightly doped layer 20 in FIG. 1.

In this selective emitter manufacturing method, two emitters of different concentrations and depths need to be made by use of the diffusion process. In addition, the accuracy (relative position and depth), of the selective emitters should also be controlled. Therefore, the process is complex and the cost is high.

In addition, for the silicon material, an optical absorption coefficient α becomes great (greater than 10⁵ cm⁻¹), when an optical wavelength λ is less than 400 nm, that is, incident blue light is quickly absorbed upon reaching the silicon surface. Therefore, it is generally considered to make the depth of the shallow junction (for example, the foregoing N-type junction), less than 0.3 µm, which is also in compliance with the diffusion property that doping at low concentration results in low depth.

By designing the solar cell with selective emitters on the silicon solar cell, a current generated by the light irradiated surface is increased, and the Rc in the electrode region is reduced, thereby enabling the silicon-based solar cell to achieve maximum efficiency. Such design has therefore become the mainstream silicon solar cell design.

However, the development trend is still faced with the challenges of solar cell modularization and commercialization inevitably. For example, in the solar cell with the selective emitters in FIG. 1, the depth of the lightly doped layer 20 is less than 0.2 µm, which is in compliance with the high optical absorption of the solar cell when the wavelength is small and the depth is small, thereby enabling the solar cell to achieve optimal performance. However, this feature changes after the solar cell is modularized. That is, during the manufacturing of the solar cell module, solar cells are encapsulated by use of a glass layer and intermediate layers. The intermediate layers cover above and below the solar cells, and are usually made of ethylene vinyl acetate (EVA). EVA is short for ethylene-vinyl acetate copolymer, which is a product after heating extrusion molding. EVA has no viscosity at a normal temperature, and is easy to cut and divide. High transmittance of EVA is a main reason that EVA is used as an encapsulation material, however, such high polymer still has a high absorption coefficient in short-wave band (blue optical band). Therefore, in the encapsulated solar cell module, due to the absorption property of the glass layer and EVA in the short-wave band, some light of a short wavelength is easily absorbed (for example, the optical band in which the wavelength is less than 400 nm), causing actual efficiency of the solar cell module to be lower than efficiency of the original cell, which is referred to as cell to module loss (CTM), and a CTM value thereof is about 3% to 6%. That is to say, in the solar cell designed with a shallow junction, although high currents are obtained at the cell end, most of the high currents are attributed to the short-wave band. Therefore, when the solar cell is utilized at the module end, a lot of the short-wave bands which originally can improve the photoelectric efficiency are absorbed by the glass or EVA. Unless the glass or EVA material is improved during module encapsulation, the solar cell design that increases blue light absorption (blue response), is inappropriate since the high CTM affects the power generation efficiency at the module end.

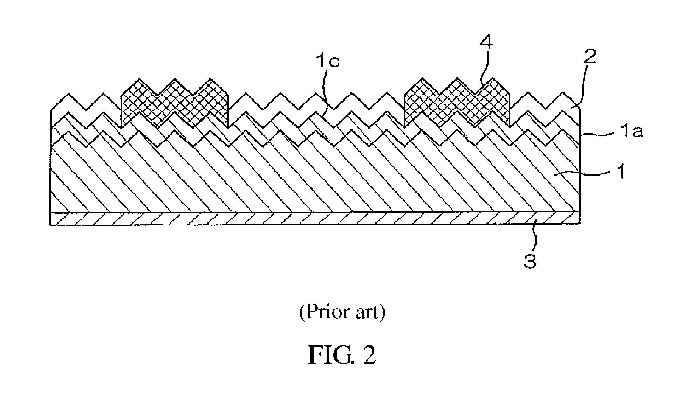

Please refer to FIG. 2, which is a schematic sectional view of a solar cell with a diffusion layer according to another prior art US 8,148,194. The solar cell has a silicon substrate 1 of one conductive type and an opposite conductivity type doped layer 1a in a surface of a silicon substrate. In this prior art, the phosphorous dopant is diffused at a density of 1×10¹⁷ atoms/cm³ and the diffusion depth is about 0.2-0.5 µm, so that an opposite conductivity type doped layer 1a is formed on the surface of the silicon substrate 1 and the doped layer 1a has a sheet resistance of 60-300 ohms/square. An antireflective film 2 is formed on the opposite conductivity type doped layer 1a and the thickness of the antireflective film 2 is about 850Å.

Although the solar cell disclosed in US 8,148,194 has an opposite conductivity type diffusion layer on the surface of semiconductor substrate and an antireflective film on the diffusion layer, the prior art does not disclose using proper dopant concentration, proper doped depth and specific antireflective films to reduce the CTM and improve the performance of the solar cell.

Therefore, it is an important task in the solar energy manufacturing industry to provide a solar cell, in which the surface recombination at the interface of the doped layer is reduced, and a proper value of Rc between the electrodes and doped layer is achieved, thereby achieving proper solar cell photoelectric conversion efficiency, and meanwhile, the production cost is reduced, and the CTM loss is minimum.

### SUMMARY

In view of the foregoing problems in the prior art, the present invention provides a solar cell, which includes a silicon semiconductor substrate, a composite multifunctional protective film, a plurality of front electrodes and a plurality of back electrodes, that means the solar cell comprises at least two front electrodes and at least two back electrodes. The silicon semiconductor substrate has a roughened first surface. A doped layer is arranged under the first surface. A depth of the doped layer ranges from 200 nm to 1000 nm. A surface doping concentration of the doped layer ranges from 1×10¹⁹ to 5×10²⁰ atoms/cm³. The composite multifunctional protective film is disposed above the doped layer. The composite multifunctional protective film has a plurality of layers, so as to reduce reflectance of incident light. The composite multifunctional protective film has at least two layers, and the layer thickness of the layer closest to the doped layer among the said layers of the composite multifunctional protective film is less than 40 nm. The plurality of front electrodes penetrates the composite multifunctional protective film and is disposed on the doped layer. The plurality of back electrodes is disposed on a second surface of the silicon semiconductor substrate.

The present invention further provides a solar cell module, which includes a plurality of solar cells, a glass layer, intermediate layers, a back plate and a fixing frame. The solar cells are connected in series and/or in parallel, and each solar cell has a light receiving surface. Each solar cell includes a silicon semiconductor substrate, a composite multifunctional protective film, a plurality of front electrodes, and a plurality of back electrodes. The silicon semiconductor substrate has a roughened first surface. A doped layer is arranged under the first surface. A depth of the doped layer ranges from 200 nm to 1000 nm from the first surface. A surface doping concentration of the doped layer ranges from 1×10¹⁹ to 5×10²⁰ atoms/cm³. The composite multifunctional protective film is disposed above the doped layer. The composite multifunctional protective film has a plurality of layers, so as to reduce reflectance of incident light. A layer thickness of a layer closest to the doped layer among these layers is less than 40 nm. The plurality of front electrodes penetrates the composite multifunctional protective film and is disposed on the doped layer. The plurality of back electrodes is disposed on a second surface of the silicon semiconductor substrate. The intermediate layers are respectively arranged above and below the solar cells to encapsulate the solar cells. The glass layer covers the intermediate layer on the light receiving surfaces of the solar cells. The back plate covers the intermediate layer below the solar cells. The fixing frame is arranged on the periphery of the solar cells, and is integrated with the glass layer and the back plate to form a frame that protects the solar cells.

By use of the solar cell of the present invention, surface recombination at the interface of the doped layer of the solar cell is reduced, and a proper value of Rc between electrodes and the doped layer is achieved, thereby achieving proper solar cell photoelectric conversion efficiency, and meanwhile, the production cost can be reduced, and the CTM loss is made minimum, which has become an important task in the solar energy manufacturing industry.

The detailed features and advantages of the present invention are described below in great detail through the following embodiments. The content of the detailed description is sufficient for persons skilled in the art to understand the technical content of the present invention and to implement the present invention accordingly. Based upon the content of the specification, the claims, and the drawings, persons skilled in the art can easily understand the relevant objectives and advantages of the present invention.

### BRIEF DESCRIPTION OF THE DRAWINGS

The present invention will become more fully understood from the detailed description given herein below for illustration only, and thus not limitative of the present invention, wherein:
FIG. 1 is a schematic sectional view of a solar cell with selective emitters according to the prior art;
FIG. 2 is a schematic sectional view of a solar cell with selective emitters according to another prior art;
FIG. 3 is a schematic sectional view of a solar cell with a single emitter doped layer according to the present invention;
FIG. 4 is a comparison view of Voc, Isc, Rs, fill factor (FF) and CTM based on different surface doping concentrations and surface doping depths in the prior art and the present invention; and
FIG. 5 is a schematic sectional view of a solar cell module according to the present invention.

### DETAILED DESCRIPTION

In order to reduce the production cost and achieve the minimum CTM loss, thereby obtaining the maximum overall efficiency of the solar cell module, the present invention implements optimal solar cell performance by controlling proper concentration and depth of a doped layer.

First, in the prior art, based on the design thinking that a solar PN junction can effectively absorb light of a short wavelength, it is considered to adjust the doping concentration to a low surface concentration, for example, 5×10¹⁸ atoms/cm³, so as to obtain a shallow emitter depth correspondingly, for example, less than 0.2 µm. Then, an electrode contact region part (namely, the selective emitter) is made by use of a high doping concentration, for example, greater than 5×10²⁰ atoms/cm³, so as to obtain a deep emitter depth, for example, deeper than 1 µm. Such design thinking reflects the bias of designers, who think that a silicon-based solar cell made by this method exhibits optimal efficiency.

The present invention breaks through this bias, and adopts a medium doping concentration, for example, a surface doping concentration of a doped layer ranges from 1×10¹⁹ to 5×10²⁰ atoms/cm³, and a medium depth of the doped layer, which, for example, ranges from 200 nm to 1000 nm, so as to make a single-doped emitter. The objective is to obtain optimal solar power generation efficiency, and achieve a minimum CTM loss, thereby acquiring an advantage on overall performance and production cost of the solar cell module. The descriptions are as follows.

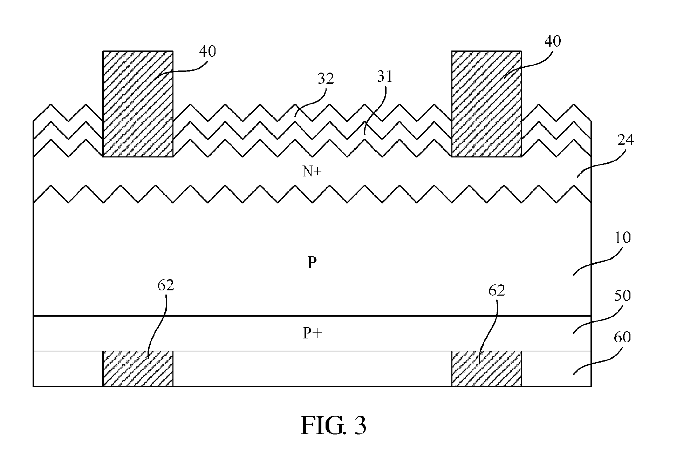

Please refer to FIG. 3, which is a schematic sectional view of a solar cell with a single emitter doped layer according to the present invention. The proportional relation of structures in FIG. 3 may be different from actual proportions of the structures for ease of display and description, and therefore, the proportional relation is only for reference purpose rather than limiting the present invention. The solar cell includes a silicon semiconductor substrate 10, surface electrodes 40, an ARC 32, an ARC 31, a doped layer 24, a silicon semiconductor substrate 10 (P-type semiconductor substrate), a P+ doped layer 50, a back electrode layer 60 and back electrodes 62. The silicon semiconductor substrate 10 has a roughened first surface. A doped layer 24 is disposed under the roughened first surface. A depth of the doped layer 24 ranges from 200 nm to 1000 nm. A surface doping concentration of the doped layer 24 ranges from 1×10¹⁹ to 5×10²⁰ atoms/cm³. The ARC 32 and the ARC 31 represent a composite multifunctional protective film, and the composite multifunctional protective film is disposed above the doped layer 24. The composite multifunctional protective film has a plurality of layers, which can reduce reflectance of incident light. The layer thickness of a layer of the composite multifunctional protective film, which is closest to the doped layer 24, is less than 40 nm; otherwise, on the optical ARC, silicon oxide of an excessive thickness is sandwiched between silicon nitride and silicon, failing to effectively reduce the reflectance. The front electrodes 40 penetrate the composite multifunctional protective film and are disposed on the doped layer 24. The back electrodes 62 are disposed on a second surface of the silicon semiconductor substrate 10, namely, a back surface thereof. The back electrodes 62 are formed in the back electrode layer 60.

The silicon semiconductor substrate 10 may be a photoelectric conversion substrate, and the silicon semiconductor substrate 10 may further be a monocrystalline silicon substrate, a polycrystalline silicon substrate, and so on. The silicon semiconductor substrate 10 is an N-type semiconductor substrate in this embodiment, and may be a P-type semiconductor substrate in another embodiment. The silicon semiconductor substrate 10 of this embodiment has a first surface (the front surface), which is a light incident surface, and a second surface (the back surface), which is a surface without incident light.

The doped layer 24 is formed by performing counter-doping in the surface of the silicon semiconductor substrate 10, and the doping may be performed by diffusion or ion implantation. When the silicon semiconductor substrate 10 is a P-type semiconductor substrate, an N-type doping element is used in the counter-doping, which is, for example, but not limited to, phosphorus, arsenic, antimony, bismuth or a combination of two or more thereof. When the silicon semiconductor substrate 10 is an N-type semiconductor substrate, a P-type doping element is used in the counter doping, which is, for example, but not limited to, boron, aluminum, gallium, indium, thallium or a combination of two or more thereof.

The first surface of the silicon semiconductor substrate 10 is the surface of the doped layer 24, and a bottom surface of the doped layer 24 forms a P-N junction around which a carrier depletion region will be formed. The carrier depletion region provides a built-in electric field which transfers generated free electrons to an N electrode, and transfers holes to a P electrode. Consequently, a current is generated. At this time, the electric power generated by the solar cell can be utilized as long as two ends are connected through an external circuit.

In addition, the doped layer 24 of this embodiment further has a surface doping concentration and a depth "d". The surface doping concentration refers to a concentration of the doping element in the surface of the doped layer 24. In this embodiment, the phosphorus element (the N-type semiconductor material), is doped into the P-type silicon semiconductor substrate 10, so as to form the N-type doped layer 24. The surface doping concentration refers to a concentration of the phosphorus element in the surface of the doped layer 24, and the surface doping concentration ranges from 1×10¹⁹ to 5×10²⁰ atoms/cm³. The depth d of the doped layer 24 ranges from 200 nm to 1000 nm.

In another embodiment, the depth of the doped layer ranges from 400 nm to 800 nm, and the surface doping concentration of the doped layer ranges from 1×10²⁰ to 5×10²⁰ atoms/cm³.

In still another embodiment, the depth of the doped layer ranges from 400 nm to 1000 nm, and the surface doping concentration of the doped layer ranges from 5x10¹⁹ to 5×10²⁰ atoms/cm³.

In still another embodiment, the depth of the doped layer ranges from 300 nm to 900 nm, and the surface doping concentration of the doped layer ranges from 5×10¹⁹ to 4×10²⁰ atoms/cm³.

In the solar cell of this embodiment, the surface doping concentration of the doped layer 24 is higher than the surface doping concentration in the prior art, thereby obtaining a proper Rc and a proper Isc. In addition, the depth of the doped layer 24 is proper, so as to reduce the CTM loss, thereby optimizing a solar cell module made subsequently.

The composite multifunctional protective film is disposed above the doped layer, that is, the composite multifunctional protective film is disposed on the surface (the light incident surface), of the silicon semiconductor substrate 10. The composite multifunctional protective film has a plurality of layers. In this embodiment, the composite multifunctional protective film having the ARC 32 and the ARC 31 is taken as an example, which, however, is not intended to limit the present invention. Persons of ordinary skill in the art should understand that the composite multifunctional protective film may be formed by more layers according to actual requirements. It should be noted that the thickness of the ARC 31 of this embodiment is less than 40 nm.

In this embodiment, the ARC 32 may be designed to have a protection function, while the ARC 31 may be designed to have a passivation function, which can reduce a carrier recombination velocity on the surface of the solar cell, so as to improve photoelectric conversion efficiency. With a proper thickness combination, the ARC 32 and the ARC 31 may also have an anti-reflection effect, passivate the silicon surface, and meanwhile protect the solar cell and achieve efficacies of preventing scratching and moisture.

Since refractive indexes of air and silicon are significantly different, an obvious reflection of light occurs when the light passes through an interface between the air and silicon. For the monocrystalline silicon, the light reflectance on the silicon surface under normal irradiation is about 30% to 35%. The optical ARC formed by the combination of the ARC 32 and the ARC 31 can reduce the reflectance of the light. More specifically, when a material of the ARC 32 and the ARC 31 has a refractive index between those of air and silicon, and the ARC 32 and ARC 31 have proper thicknesses, based on an optical destructive interference principle, the reflectance of the incident light is effectively reduced, and the amount of light entering the solar cell is increased, thereby improving the photoelectric conversion efficiency.

The material of the ARC 32 of this embodiment is, for example, silicon nitride (SiNx), and the material of the ARC 31 is, for example, silicon oxide (SiO₂) or aluminum oxide (Al₂O₃), which are not intended to limit the present invention. The material of the ARC 31 may also be other materials capable of performing anti-reflection on the silicon surface, and the material of the ARC 32 may also be other materials capable of performing passivation.

In order to achieve the function as above description in this embodiment of the present invention, the thickness of the ARC 31 of this embodiment is less than 40 nm, and the composite multifunctional protective film has good passivation property. The composite multifunctional protective film has lower light transmittance when the ARC 31 becomes too thick. The passivation property and the light transmittance of the composite multifunctional protective film may be further improved by selecting the ARC 31 with lower refractive index and the ARC 32 with higher refractive index, wherein the refractive index of the ARC 31 is lower than the refractive index of the ARC 32.

The front electrodes 40 may be electrodes made of a silver paste. The back electrode layer 60 may be an electrode layer made of a material comprising aluminum, and the back electrodes 62 are made of a silver paste. In addition, the front electrode 40 may be formed by a plurality of bus bar electrodes and a plurality of finger electrodes that is arranged and connected at two sides of the bus bar electrodes. Therefore, when the solar cell converts the absorbed light into electrons or holes, the finger electrodes may be used to collect the electrons or holes generated by the solar cell at the bus bar electrodes connected thereto, and finally the electrons or holes generated after the photoelectric conversion reaction are gathered and transferred to the outside through a connection between the bus bar electrodes and an external load.

Compared with the prior art which adopts the design thinking of a shallow junction of the light incident surface, the solar cell of the present invention adopts the design thinking of a deep junction of the light incident surface. Therefore, the doped layer 24 provides lower emitter sheet resistance and leads to higher fill factor and lower Isc. As a result, the solar cell of the present invention is made into a solar cell module, thereby achieving a low CTM.

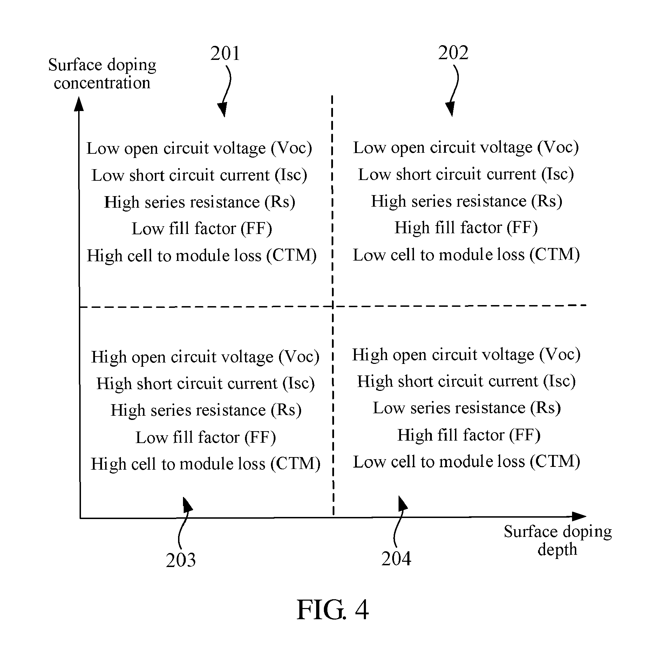

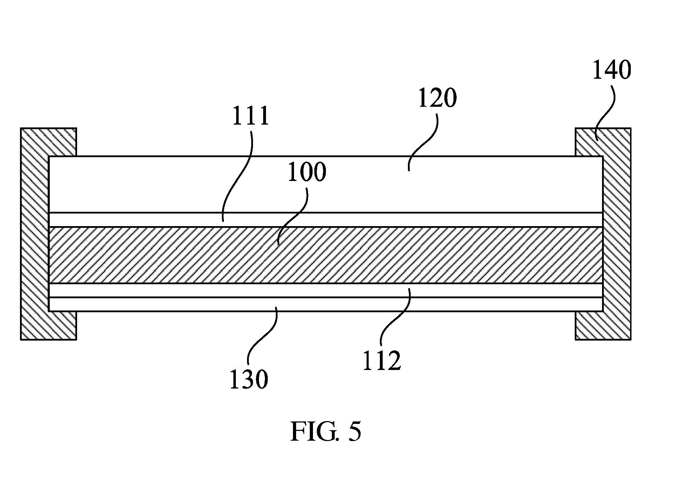

Please refer to FIG. 4, which is a comparison view of Voc, Isc, Rs, fill factor (FF) and CTM based on different surface doping concentrations and surface doping depths. In FIG. 4, a first quadrant 201 represents a high surface doping concentration and a shallow surface doping depth, a second quadrant 202 represents a high surface doping concentration and a deep surface doping depth, a third quadrant 203 represents a low surface doping concentration and a shallow surface doping depth, and a fourth quadrant 204 represents a low surface doping concentration and a deep surface doping depth. In the first quadrant 201, the surface doping concentration is high and the surface doping depth is shallow, resulting in a low Voc, a low Isc, a high Rs, a low FF and a high CTM. In the second quadrant 202, the surface doping concentration is high and the surface doping depth is great, resulting in a low Voc, a low Isc, a high Rs, a high FF and a low CTM. In the third quadrant 203, the surface doping concentration is low and the surface doping depth is shallow, resulting in a high Voc, a low Isc, a high Rs, a low FF and a high CTM. In the fourth quadrant 204, the surface doping concentration is low and the surface doping depth is great, resulting in a high Voc, a high Isc, a low Rs, a high FF and a low CTM. The design of the solar cell in the prior art usually falls within the second quadrant and the third quadrant, while the design of the solar cell of the present invention falls within the fourth quadrant. Therefore, the total power generation efficiency of the final solar cell module of the present invention is better than that of the shallow junction solar cell design or selective emitter solar cell design in the prior art. Therefore, the present invention further discloses a solar cell module. Please refer to FIG. 5, which is a schematic sectional view of the solar cell module using the solar cell in FIG. 3 of the present invention. In the solar cell module of the present invention, multiple solar cells 100 are used and the solar cells 100 are connected in series and/or in parallel, and intermediate layers 111 and 112 are arranged above and below the solar cells 100 to encapsulate the solar cells 100. The intermediate layers 111 and 112 may adopt an EVA material. Then, a glass layer 120 is used to cover the intermediate layer 111 on light receiving surfaces of the solar cells 100. A back plate 130 is used to cover the intermediate layer 112 below the solar cells 100. Finally, a fixing frame 140 is used and arranged on the periphery of the solar cells 100. The fixing frame 140 is integrated with the glass layer 120 and the back plate 130 to form a frame that protects the solar cells 100. The fixing frame 140 may be an aluminum frame.

For the overall performance of the solar cell according to the present invention in a lab, when a depth of the doped layer ranges from 200 nm to 1000 nm, and a surface doping concentration of the doped layer ranges from 1×10¹⁹ to 5×10²⁰ atoms/cm³, the power generation efficiency is 19.4%, and the CTM is about 1.5%.

When the depth of the doped layer ranges from 400 nm to 800 nm, and the surface doping concentration of the doped layer ranges from 1×10²⁰ to 5×10²⁰ atoms/cm³, the power generation efficiency is 19.5%, and the CTM is about 2.0%.

When the depth of the doped layer ranges from 400 nm to 1000 nm, and the surface doping concentration of the doped layer ranges from 5×10⁹ to 5×10²⁰ atoms/cm³, the power generation efficiency is 19.4%, and the CTM is about 1.5%.

When the depth of the doped layer ranges from 300 nm to 900 nm, and the surface doping concentration of the doped layer ranges from 5×10¹⁹ to 4×10²⁰ atoms/cm³, the power generation efficiency is 19.2%, and the CTM is about 1.2%.

According to the above data, the present invention can indeed achieve the specific function of reducing the CTM, which is the efficacy that cannot be anticipated from the prior art; in addition, the process is relatively simple (much simpler than the selective emitter design), thereby substantially reducing the production cost.

The above description is merely exemplary but is not intended to limit the present invention. Any equivalent modification or alteration made without departing from the spirit and scope of the present invention shall fall within the scope of the appended claims.

While the present invention has been described by the way of example and in terms of the preferred embodiments, it is to be understood that the invention need not be limited to the disclosed embodiments. On the contrary, it is intended to cover various modifications and similar arrangements included within the spirit and scope of the appended claims, the scope of which should be accorded the broadest interpretation so as to encompass all such modifications and similar structures.

## Claims

1. A solar cell, comprising:
a silicon semiconductor substrate (10), having a first surface, wherein a doped layer (24) is arranged under the first surface, a depth of the doped layer ranges from 200 nm to 1000 nm, and a surface doping concentration of the doped layer (24) ranges from 1×10¹⁹ to 5×10²⁰ atoms/cm³; and
a composite multifunctional protective film, disposed above the doped layer (24), wherein the composite multifunctional protective film has a plurality of layers (31,32), so as to reduce reflectance of incident light, and a layer thickness of a layer closest to the doped layer (24) among the layers is less than 40 nm.

2. The solar cell according to claim 1, wherein the silicon semiconductor substrate (10) is a P-type semiconductor substrate or an N-type semiconductor substrate.

3. The solar cell according to claim 2, wherein when the silicon semiconductor substrate (10) is a P-type semiconductor substrate, a doping element of the doped layer is N-type.

4. The solar cell according to claim 2, wherein when the silicon semiconductor substrate (10) is an N-type semiconductor substrate, a doping element of the doped layer is P-type.

5. The solar cell according to claim 1, wherein the depth of the doped layer (24) ranges from 400 nm to 800 nm, and the surface doping concentration of the doped layer (24) ranges from 1×10²⁰ to 5×10²⁰ atoms/cm³.

6. The solar cell according to claim 1, wherein the depth of the doped layer (24) ranges from 400 nm to 1000 nm, and the surface doping concentration of the doped layer (24) ranges from 5×10¹⁹ to 5×10²⁰ atoms/cm³.

7. The solar cell according to claim 1, wherein the depth of the doped layer (24) ranges from 300 nm to 900 nm, and the surface doping concentration of the doped layer (24) ranges from 5×10¹⁹ to 4×10²⁰ atoms/cm³.

8. The solar cell according to claim 1, wherein the doped layer (24) formed at the front electrodes and the doped layer (24) not formed at the front electrodes have the same depth and surface doping concentration.

9. A solar cell module, comprising:
a plurality of solar cells (100), wherein the solar cells are connected in series and/or in parallel connected, each of the solar cells has a light receiving surface, and each of the solar cells comprises:
a silicon semiconductor substrate (10), having a roughened first surface, wherein a doped layer (24) is arranged under the first surface, a depth of the doped layer (24) ranges from 200 nm to 1000 nm, and a surface doping concentration of the doped layer (24) ranges from 1×10¹⁹ to 5×10²⁰ atoms/cm³; and
a composite multifunctional protective film, disposed above the doped layer (24) to form the light receiving surface, wherein the composite multifunctional protective film has a plurality of layers (31,32), so as to reduce reflectance of incident light, and a layer thickness of a layer closest to the doped layer (24) among the layers is less than 40 nm;
two intermediate layers (111, 112), respectively allocated above and below the solar cells to encapsulate the plurality of solar cells;
a glass layer (120), covering the intermediate layer (111 or 112) on the light receiving surfaces of the solar cells; a back plate (130), covering the intermediate layer (111 or 112) below the plurality of solar cells; and
a fixing frame (140), arranged on the periphery of the solar cells, and integrated with the glass layer (120) and the back plate (130) to form a frame that protects the plurality of solar cells.

10. The solar cell module according to claim 9, wherein the silicon semiconductor substrate (10) is a P-type semiconductor substrate or an N-type semiconductor substrate.

11. The solar cell module according to claim 10, wherein when the silicon semiconductor substrate (10) is a P-type semiconductor substrate, a doping element of the doped layer is N-type.

12. The solar cell module according to claim 10, wherein when the silicon semiconductor substrate is (10) an N-type semiconductor substrate, a doping element of the doped layer is P-type.

13. The solar cell module according to claim 9, wherein the depth of the doped layer (24) ranges from 400 nm to 800 nm, and the surface doping concentration of the doped layer (24) ranges from 1×10²⁰ to 5×10²⁰ atoms/cm³.

14. The solar cell module according to claim 9, wherein the depth of the doped layer (24) ranges from 400 nm to 1000 nm, and the surface doping concentration of the doped layer (24) ranges from 5×10¹⁹ to 5×10²⁰ atoms/cm³.

15. The solar cell module according to claim 9, wherein the depth of the doped layer (24) ranges from 300 nm to 900 nm, and the surface doping concentration of the doped layer (24) ranges from 5×10¹⁹ to 4×10²⁰ atoms/cm³.
